# EUROPEAN PATENT APPLICATION

(11) **EP 1 837 695 A1**
(43) Date of publication of application: **26.09.2007**
(21) Application number: 06005813.8
(22) Date of filing: 22.03.2006
(51) Int. Cl.: G02B 17/08, G03F 7/20

(54) **Catadioptric imaging system with beam splitter**

(71) Applicant: Carl Zeiss SMT AG, 73447 Oberkochen (DE)
(72) Inventor: Dodoc, Aurelian, 73447 Oberkochen (DE)
(74) Representative: Patentanwälte Ruff, Wilhelm, Beier, Dauster & Partner

(57) **Abstract**

A catadioptric imaging system (100') for imaging a reticle arranged in an object surface (OS) onto an image field (substrate) arranged in the image plane (IS) while creating several intermediate images (IMI1-3) has at least two imaging subsystems (SS1-4) separated by said intermediate images relayed by said subsystems. Each imaging subsystem includes a pupil surface (PS1-4) and one of the imaging subsystems (SS2) is a catadioptric or catoptric imaging subsystem including a concave mirror (CM2). The imaging system includes a beam splitter (BS) having one planar beam splitter surface (BSS), the beam splitter surface being arranged at or optically near to a pupil surface (PS1,PS3). Such catadioptric system is preferably designed for microlithography and for producing a reduced image parallel to the object reticle.

## Description

### BACKGROUND OF THE INVENTION

### Field of the Invention

The invention relates to a catadioptric imaging system for imaging an object field arranged in an object surface of the imaging system onto an image field arranged in an image surface of the imaging system while creating at least one intermediate image. In a preferred field of application the imaging system is designed as a catadioptric projection objective for a microlithographic projection exposure system designed for projection using radiation in the ultraviolet spectrum or as a partial system within such a projection objective.

### Description of the Related Art

Catadioptric projection objectives are, for example, employed in projection exposure systems, in particular wafer scanners or wafer steppers, used for fabricating semiconductor devices and other types of micro-devices and serve to project patterns on photomasks or reticles, hereinafter referred to generically as "masks" or "reticles," onto an object having a photosensitive coating with ultrahigh resolution on a reduced scale.

In order to create even finer structures, it is sought to both increase the image-end numerical aperture (NA) of the projection objective and employ shorter wavelengths, preferably ultraviolet light with wavelengths less than about 260 nm. However, there are very few materials, in particular, synthetic quartz glass (fused silica) and crystalline fluorides, that are sufficiently transparent in that wavelength region available for fabricating the optical elements required. Since the Abbe numbers of those materials that are available lie rather close to one another, it is difficult to provide purely refractive systems that are sufficiently well color-corrected (corrected for chromatic aberrations).

In optical lithography, high resolution and good correction status have to be obtained for a relatively large, virtually planar image field. It has been pointed out that the most difficult requirement that one can ask of any optical design is that it has a flat image, especially if it is an all-refractive design. Providing a flat image requires opposing lens powers and that leads to stronger lenses, more system length, larger system glass mass, and larger higher-order image aberrations that result from the stronger lens curvatures.

In view of the aforementioned problems, catadioptric systems that combine refracting and reflecting elements, i.e., in particular, lenses and concave mirrors, are primarily employed for configuring high-resolution projection objectives of the aforementioned type.

Concave mirrors in optical imaging systems have been used for some time to help solve problems of color correction and image flattening. A concave mirror has positive power, like a positive lens, but the opposite sign of Petzval curvature. Also, concave mirrors do not produce color problems. Unfortunately, a concave mirror is difficult to integrate into an optical system, since it sends the radiation right back in the direction it came from. Therefore, intelligent concepts have to be employed to separate radiation running towards a concave mirror from radiation reflected by that concave mirror. Many conventional designs employ a beam splitter for that purpose. In the context of this application, a beam splitter is an optical device including at least one planar beam splitter surface capable of reflecting the utilized radiation. Both systems having a geometric beam splitter and the systems having a physical beam splitter are known.

In conventional systems employing a geometric beam splitter, an off-axis field must be used if an image free of pupil obscuration and beam vignetting is desired. However, when using an off-axis field the diameter for which an optical system must be sufficiently corrected becomes relatively larger when compared to systems having an object field centered around the optical axis. This increases the demands for correcting imaging errors and typically optical elements with larger diameters are needed. Further, with off-axis fields it is more difficult to obtain a large geometrical light guidance value (etendue), i.e. large values for the product of the image field size and image side numerical aperture.

In contrast, employing a physical beam splitter allows configuring on-axis systems, i.e. systems having an object field and image field centered about the optical axis. In the field of lithography, beam splitters having a polarization selective beam splitter surface (also called polarizing beam splitter) are frequently used. In view of the high prizes and limited availability of material blocks in sizes large enough for fabricating the large transparent optical element, efforts have been made to design optical imaging systems having a relatively small size beam splitter. For example, US 5,861,997 discloses a catadioptric projection objective having a first, refractive subsystem for imaging the object field into an intermediate image, and a second, catadioptric subsystem for imaging the intermediate image onto the image plane. A polarizing beam splitter is arranged within the catadioptric subsystem near the position of the intermediate image, whereby a small size of the beam splitter is obtained. International patent application WO 03/027747 A1 (corresponding to US application 10/805,393) by the applicant discloses a catadioptric projection objective having a first, catadioptric subsystem for generating an intermediate image, and a second, refractive imaging subsystem for imaging the intermediate image onto the image plane. A physical beam splitter is arranged within the catadioptric imaging subsystem in a region of small marginal-ray heights optically close to the object surface and/or to the intermediate image, whereby a beam splitter with moderate size can be used. Arranging a beam splitter surface close to a field surface (object surface and/or intermediate image surface) imposes stringent demands on the quality of the polarization selective coating system forming the beam splitter surface since the range of incidence angles occurring at the beam splitter surfaces becomes very broad as the aperture of the beam impinging on the beam splitter surface increases.

Large incidence angles on beam splitter surfaces may also occur in the case of concatenated systems where an intermediate image is created in the vicinity of a beam splitter surface. Examples for designs with geometric beam splitting or physical beam splitting are shown in US 5,808,805.

Another class of catadioptric projection objectives having a physical beam splitter utilizes a direct imaging between object surface and image surface, such that no intermediate image is formed. Examples of this type having a polarizing beam splitter positioned between the object surface and the pupil surface (where the aperture stop is placed) are shown in US 6,765,729 B2 or US 6,081,382. US 6,108,140 or US 5,796,524 disclose systems of this type having the beam splitter surface close to the aperture stop position. In these systems the angular load (i.e. the range of incidence angles impinging on the beam splitter surface) is generally smaller than in systems having a beam splitter close to a field surface, thereby relaxing the requirements for the beam splitter coating. However, the beam splitter tends to become large as the image-side numerical aperture is increased.

### SUMMARY OF THE INVENTION

It is one object of the invention to provide a catadioptric imaging system capable of high image-side numerical aperture NA where a beam splitter with moderate size is used and where the angular load of radiation impinging on a beam splitter surface is small. It is another object of the invention to provide a catadioptric imaging system with on-axis object field and image field which avoids the problems characteristic of physical beam splitters, such as polarizing beam splitters.

As a solution to these and other objects of the invention, according to one formulation, provides a catadioptric imaging system for imaging an object field arranged in an object surface of the imaging system onto an image field arranged in an image surface of the imaging system while creating at least one intermediate image comprising:
at least two imaging subsystems concatenated at an intermediate image such that the intermediate image formed by an imaging subsystem immediately upstream of that intermediate image forms the object of a subsequent imaging subsystem immediately downstream of that intermediate image, wherein each imaging subsystem includes a pupil surface and at least one of the imaging subsystems is a catadioptric or catoptric imaging subsystem including a concave mirror;
a beam splitter having at least one planar beam splitter surface;
the beam splitter surface being arranged at or optically near to a pupil surface.

According to this aspect of the invention the beam splitter surface is arranged in a region of the optical path where the rays constituing the radiation beam between object field and image field may be essentially parallel to each other such that only a small spectrum of ray angles (angles between a ray and the optical axis) is given. Typical ray angles may be in the range between 0° and about 30°, for example. Under these conditions, the angular load of the beam splitter surface can be kept small such that an interference coating having high efficiency for reflection and/or polarization selection can be used on the beam splitter surface. Providing at least two concatenated imaging subsystems and at least one intermediate image allows, to a limited the extent, to decouple the image-side numerical aperture NA from aperture values within the optical system by providing specific combinations of respective magnification ratios of the imaging subsystems, whereby an intermediate image with moderate aperture can be obtained even though the image-side numerical aperture may be high, such as in typical projection objectives for microlithography where NA > 0,6 or NA ≥ 0,85 or even NA ≥ 1 (as in imaging systems for immersion lithography). Where regions with moderate aperture are created within the optical system, the angular load on the optical elements may be kept small.

Preferred embodiments of imaging systems have NA > 0,6.

Generally, the angular load at a beam splitter surface may be considered to have two components, namely the variation of ray angles of incidence in the pupil surface and the variation of ray angles of incidence with ray pupil position. If the object for the lens group in front of the beam splitting surface is near to the focal plane of this lens group, then the rays are almost parallel in the region of the pupil, such that the angular spectrum is very small. This corresponds to a small variation of angles of incidence. The pupil variation may be significantly larger if the object position deviates significantly from the mentioned focal plane.

Regarding the positioning of a beam splitter a beam splitter close to a field surface may be advantageous if the conditions at the pupil are not suitable for beam splitting. Placing a beam splitter close to a field surface allows to keep the dimensions of the beam splitter small, but the angular load is higher. If an imaging subsystem is purely refractive, then a beam splitter could be positioned in the pupil surface, which position would allow small dimensions of the beam splitter, especially if the subsystem is nearly double telecentric, i.e. the chief ray is nearly parallel to the optical axis in object and image space and the magnification is close to |β|=1..

The beam splitter surface is arranged at or optically near to a pupil surface. A position of a beam splitter surface at a pupil surface is given if a plane defined by the beam splitter surface (which is inclined to the optical axis) intersects the optical axis essentially at a position where the chief ray of the imaging process intersects the optical axis. Here, the chief ray is a ray running from an outermost object field point (farthest away from the optical axis) parallel to or at small angle with respect to the optical axis and intersecting the optical axis at a pupil surface position. A position "optically near to a pupil surface" is a position optically nearer to a pupil surface than to a field surface. Preferred positions optically near to a pupil surface i.e. within an optical vicinity of a pupil surface, may be characterized by a ray height ratio H = h_{C}/h_{M} << 1, where h_{C} is the height of the chief ray and h_{M} is the height of the marginal ray of the imaging process. The marginal ray height h_{M} is the height of a marginal ray running from an inner field point (closest to the optical axis) to the edge of an aperture stop. For example, the condition H ≤ 0,1 may hold. Preferably H ≤ 0,01 and/or H = 0.

In some embodiments the beam splitter is arranged in a first imaging subsystem immediately downstream of the object surface. In imaging systems having overall reducing effect, such as reduction projection optical systems for microlithography, particularly small ray angles can be obtained in the first imaging subsystem. Generally, the extent of the angular spectrum of rays in the pupil surface is correlated to the physical length of an imaging subsystem, e.g. to the axial distance between subsequent optically conjugate field surfaces. As this distance increases, the angular range of ray angles in the pupil generally decreases, however the beam diameter increases at the pupil surface.

In some embodiments the beam splitter is a physical beam splitter having at least one polarization selective beam splitter surface. Such beam splitter surfaces are designed to fully reflect or fully transmit radiation depending on the orientation of the electrical field vector of linearily polarized radiation impinging on the beam splitter surface. The object field and image field can be positioned symmetrically around the optical axis (on-axis field), thereby reducing the etendue (geometrical flux) without vignetting.

According to one embodiment the beam splitter has a first beam splitter surface inclined to the optical axis about a first tilt axis to define a first beam splitting plane and a second beam splitter surface inclined to the optical axis about a second tilt axis to define a second beam splitter plane inclined with respect to the first beam splitter plane, the first and second beam splitter surface being arranged at a pupil surface such that a radiation beam impinging on the first and second beam splitter surface is split into a first and at least one second partial beam with different propagation direction at the pupil surface. In this embodiment, a "pupil splitting" is effected by the beam splitter. The first and second beam splitter surface may be fully reflecting mirror surfaces arranged side by side to allow efficient geometric beam splitting. Catadioptric imaging systems with geometric beam splitting by planar beam splitter surfaces and an on-axis field can be obtained this way, whereby drawbacks of conventional systems having a geometric beam splitter (e.g. off-axis field) and drawbacks of conventional polarization beam splitters (e.g. susceptability to polarization changing influences) can be avoided.

The first beam splitter surface and the second beam splitter surface may be inclined about the same tilt axis and include a 90° angle between the beam splitter surfaces. In this case, the sections of the optical axis downstream of the first and second beam splitter surface will be coaxial, facilitating a mechanically stable construction of the optical elements and a precise reunification or reintegration of the first and second partial beam prior to forming the image.

According to another embodiment the beam splitter has a beam splitter surface entirely arranged on a first side of the optical axis such that a portion of a radiation beam impinging on the beam splitter on the first side of the optical axis is reflected by the beam splitter surface and a second portion of the radiation beam impinging on the second side of the optical axis opposite to the first side is transmitted by the beam splitter. If a beam splitter of this type is arranged at a pupil surface, a pupil splitting may be effected that allows a folding of the optical axis at one point only. In these embodiments, there is only one reflecting surface present in the beam splitter. Adjustment of the orientation of the beam splitter to obtain a correct overlay of partial images becomes easier this way.

The previous and other properties can be seen not only in the claims but also in the description and the drawings, wherein individual characteristics may be used either alone or in sub-combinations as an embodiment of the invention and in other areas and may individually represent advantageous and patentable embodiments.

### BRIEF DESCRIPTION OF THE DRAWINGS

Fig. 1 shows a schematic section through a catadioptric imaging system according to a first embodiment of the invention;
Fig. 2 shows a schematic section through a catadioptric imaging system according to a second embodiment of the invention;
Fig. 3 shows a schematic section through a catadioptric imaging system according to a third embodiment of the invention using a "pupil splitting";
Fig 4 shows different construction variants for a beam splitter suitable for incorporation into the third embodiemnt;
Fig. 5 shows a lens section through a catadioptric imaging system designed according to the principles shown in Fig. 1;
Fig. 6 shows a lens section through a catadioptric imaging system designed according to the principles shown in Fig. 2;
Fig. 7 shows a schematic section through a catadioptric imaging system according to a fourth embodiment of the invention using a "pupil splitting";
Fig. 8 shows a perspective view of the beam splitter used in the embodiment of Fig. 7.

### DETAILED DESCRIPTION OF THE PREFERRED EMBODIMENTS

In the following description of preferred embodiments of the invention, the term "optical axis" shall refer to a straight line or sequence of straight-line segments passing through the centers of curvature of the optical elements involved. The optical axis is folded at planar mirror surfaces (e.g. at deflecting mirrors) or other reflective surfaces. In the case of those examples presented here, the object involved is either a mask (reticle) bearing the pattern of an integrated circuit or some other pattern, for example, a grating pattern. In the examples presented here, the image of the object is projected onto a wafer serving as a substrate that is coated with a layer of photoresist, although other types of substrates, such as components of liquid-crystal displays or substrates for optical gratings, are also feasible.

Concatenated imaging systems are described. The term "concatenated system" as used here refers to an imaging system that includes two or more imaging subsystems that are linked together at intermediate images, where an intermediate image is the image formed by a subsystem upstream of the intermediate image and serves as the object of a subsystem downstream of the intermediate image. Throughout this specifications the terms "upstream" and "downstream" refer to relative positions along the optical path through the system, where "upstream" relates to a position optically on the object side and "downstream" refers to a position optically on the image side of a certain position along the optical path.

In this specification, a "subsystem" is an optical system designed to image an object arranged on an entry side field surface of the subsystem onto an exit side field surface of the subsystem optically conjugate to the entry side field surface without forming an intermediate image. Subsystems will therefore also be denoted as "imaging subsystem" in the following. An optical axis of a subsystem may be folded at a planar mirror surface or may be unfolded (straight).

Typically, in a concatenated system one or more refractive subsystems are combined with one or more catadioptric or catoptric subsystems. In a refractive subsystem, all optical elements having refractive power are transparent lenses. In a catadioptric or catoptric subsystem at least one curved mirror, typically a concave mirror, having refractive power contributes to image formation. Throughout this specification a sequence of subsystems may be characterized in abbreviated form by a notation where "R" designates a refractive subsystem and "C" designates a mirror subsystem, which typically is a catoptric or catadioptric imaging subsystem having a concave mirror, subsystem symbols being connected by "-", where the "-"-sign designates an intermediate image formed between the subsystems upstream and downstream of the intermediate image.

Where appropriate, identical or similar features or feature groups in different embodiments are denoted by similar reference identifications. In the following schematic representations the optical axes of imaging subsystems are characterized by dash-dotted lines. Each imaging system contains at least one concave mirror CM, a concave mirror being symbolized by a segment of a circle. Where planar folding mirrors FM are employed, these are symbolized by straight line segments. Single lenses or lens groups having overall positive refractive power are symbolized by double arrows having their arrow heads facing outside. Single lenses or lens groups having overall negative refractive power are symbolized by double arrows having arrow heads facing inwards. An object or intermediate image IMI or final image defining a field surface is symbolized by an arrow perpendicular to a respective optical axis OA. The imaging process is symbolized by a continuous line representing the chief ray CR emerging from an off-axis object point which, in the case of telecentricity, runs parallel or at a small angle with respect to the optical axis at the object. Pupil surfaces PS are disposed axially between field surfaces at axial positions where the chief ray CR intersects the optical axis.

In some embodiments the concave mirrors are positioned optically near or at pupil surfaces, similar to Schuppmann catadioptric imaging subsystems. In other embodiments, one or more concave mirrors are positioned at or close to a field surface. If a concave mirror is positioned at a field surface, then an intermediate image is imaged onto itself. A concave mirror in a field surface influences field dependent aberrations only. The chief ray is reflected in itself by the concave mirror and transits the pupil surface near the beam splitting surface.

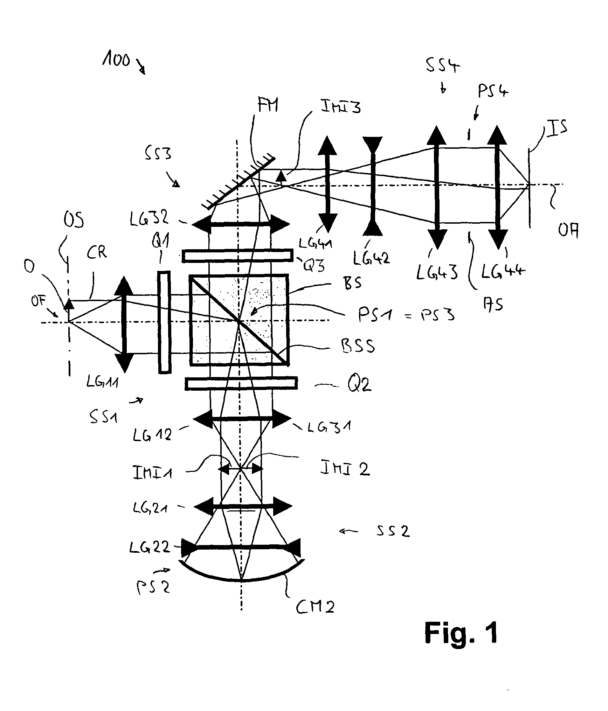

Fig. 1 shows a schematic representation of a meridional lens section of an imaging system 100 designed as a catadioptric projection objective for microlithography. The imaging system is designed to project an image of a pattern on a reticle arranged in the planar object surface OS onto the planar image surface IS oriented parallel to the object surface on a reduced scale (e.g. 4:1) while creating three real intermediate images IMI1, IMI2 and IMI3.. The imaging system consist of four consecutive imaging subsystems SS1, SS2, SS3, and SS4 concatenated at the intermediate images arranged in the sequence R-C-R-R, where "C" represents a catadioptric imaging system, "R" represents a refractive (dioptric) imaging system and "-" represents the connection between the imaging subsystems at the intermediate image.

A first, refractive imaging subsystem SS1 is effective to create a first intermediate image IMI1 from radiation coming from the object O (arrow) situated in an on-axis object field OF arranged in the object surface OS. A physical beam splitter BS in the form of rectangular beam splitter block having a planar beam splitter surface BSS inclined at 45° with respect to the optical axis OA is arranged at the first pupil surface PS1 within the first subsystem SS1 such that the planar beam splitter surface BSS intersects the optical axis at the position of the pupil surface PS1 where the chief ray CR of the imaging intersects the optical axis. A second, catadioptric imaging subsystem SS2 including a concave mirror CM2 positioned at a second pupil surface PS2 serves to image the first intermediate image IMI1 at near unit magnification (|β| = 1) into a second intermediate image IMI2. A third, refractive imaging subsystem SS3 including a planar folding mirror FM inclined at 45° to the optical axis serves to image the second intermediate image IMI2 into a third intermediate image IMI3 positioned optically downstream of the folding mirror. The beam splitter surface BSS is transited by radiation between the second and third intermediate images. A fourth, refractive subsystem SS4 having its associated part of the optical axis parallel to, but laterally offset to the object-side part of the optical axis, serves to image the third intermediate image IMI3 onto the image surface IS to form a reduced image of the object O in the planar image surface IS oriented parallel to the planar object surface OS. The object is imaged onto the image surface without vignetting, i.e. without losses in the field.

The first subsystem SS1 includes in this order along the radiation propagation direction a positive lens group LG11, a quarter wave plate (λ/4 plate) Q1, the beam splitter BS with the beam splitter surface used in reflection, a further quarter wave plate Q2 and a positive lens group LG12. In a minimum configuration (not shown) the second subsystem SS2 is a catadioptric subsystem consisting of a concave mirror CM2 only. In the shown embodiment, a positive lens group LG21 is arranged optically close to the intermediate image IMI1 and a negative lens group LG22 is placed close to the pupil surface PS2 where the concave mirror CM2 is situated. Whereas the negative lens group LG22 contributes to correction of chromatic length aberration (CHL, axial color) the positive lens group LG21 close to a field surface helps to reduce the diameter of the concave mirror and of the optional negative lenses in front thereof and may include at least one aspheric surface contributing to correction of field-dependent aberrations. The third subsystem SS3 includes, in that sequence, a positive lens group LG31 (formed by the same positive lenses as LG12), a quarter wave plate Q3 (also used twice by radiation), the beam splitter BS with the beam splitter surface BSS used in transmission, a further quarter wave plate Q4, a positive lens group LG32 and the folding mirror FM (which is optically not necessary but allows to arrange object and image surface in parallel). In an alternative embodiment (not shown) the folding mirror is arranged optically downstream of the third intermediate image IMI3 within the fourth subsystem SS3. The planar mirror may also be arranged immediately downstream of the beam splitter or within the lens group LG32 if said lens group includes two or more lenses. The fourth subsystem SS4 includes a positive lens group LG41 close to the intermediate image IMI3, a subsequent negative lens group LG42, a subsequent positive lens group LG43 immediately upstream of the image-side fourth pupil surface PS4, and another positive lens group LG44 between PS4 and the image surface IS. In other embodiments, the entry side positive lens group LG41 may be omitted to obtain a sequence N-P-P. An aperture stop AS is positioned at the fourth pupil surface PS4.

The optical system is designed for use with circularly polarized entrance radiation which is transformed into linearly s-polarized radiation by the first quarter wave plate Q1 such that the electric field vector oscillates perpendicular to the respective incidence plane on the beam splitter surface BSS such that the radiation is reflected by that beam splitter surface towards the concave mirror. The reflected radiation is transformed into circularly polarized radiation upon its first transit through the second quarter wave plate Q2 prior to reflection on the concave mirror CM2. After that reflection, the radiation is transformed into linearily polarized light upon the second transit through the second quarter wave plate Q2 to form p-polarized radiation which is transmitted by the beam splitter surface BSS essentially without reflection losses.

The third quarter wave plate Q3 downstream of the beam splitter generates circular polarization from the linear polarization such that no orientation-dependent polarization effects occur downstream of the third quarter wave plate on the folding mirror FM, within the fourth subsystem SS4 and upon image formation in the image surface.

The first subsystem forming the first intermediate image has a first magnification ratio β₁ with 0,9 < |β₁| < 1,1 such that the aperture of radiation at the first intermediate image is small. Under these conditions the radiation is almost collimated at the beam splitter surface BSS (all rays within the beam are parallel or almost parallel to the optical axis), whereby a small range of angles of incidence with typical incidence angels 45° ± 5° is obtained. A stronger variation of incidence angles on the beam splitting surface is obtained by increasing the field size. Between the marginal ray originating from a field point on the optical axis and a marginal ray originating from an outermost field point an angle of up to 20° to 30° may exist, depending on the length of the first imaging subsystem.

Due to the small variation of incidence angles in this embodiment an effective polarization selection can be obtained with a polarization selective interference coating having a simple design. In addition, the overall dimensions of the beam splitter BS can be kept small such that the lateral dimensions of the beam splitter perpendicular to the optical optical axis are substantially smaller than the respective dimensions of the concave mirror.

The main contribution to the overall reduction (e.g. 4:1 or 5:1 or 10:1 or smaller) are effected by the third and fourth subsystems. The magnification ratio β₂ of the second subsystem and the magnification ratio β₃ of the third subsystem preferably obey the conditions |β₂| < 1.2 and |β₃| < 1.2. In many cases 0,8 < |β₁|, |β₂|, |β₃|, < 1,2 may be preferable. With other words, in the first to third subsystems magnification ratios close to a unit magnification may be useful. If |β| << 1 the aperture in an intermediate image may increase more than necessary. If |β| >> 1 the field size may become unnecessarily large requiring a larger reflective surface if a folding without vignetting shall be effected at the field surface.

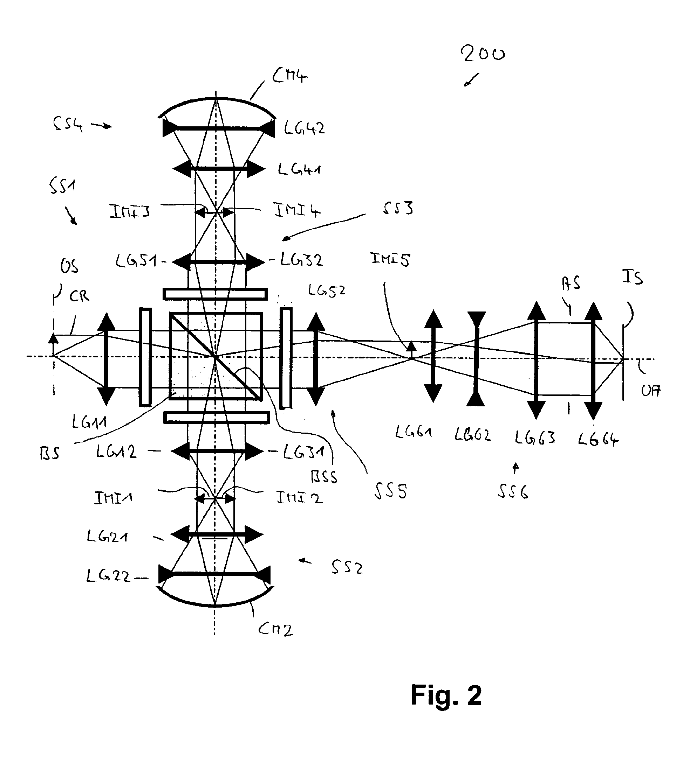

The catadioptric projection objective 200 in Fig. 2 is a variant of the system of Fig. 1 where a second catadioptric subsystem SS4 is incorporated optically behind the third, refractive subsystem SS3 and where the beam splitter BS is utilized twice in reflection, whereby a system of type R-C-R-C-R-R having six consecutive imaging subsystems SS1 to SS6 and five intermediate images IMI1 to IMI5 is obtained. The beam splitter BS is used three times in this configuration, twice in reflection and once in transmission. Providing a second catadioptric subsystem including a further concave mirror CM4 facilitates correction of image curvature and axial color since additional correcting means independent of the other catadioptric subsystem SS2 are provided.

The optical function and structure is basically the same as in the system of Fig. 1 up to the third, refractive subsystem forming the third intermediate image IMI3 with a difference that the folding mirror FM is removed such that the third subsystem SS3 has a straight, unfolded part of the optical axis. The fourth, catadioptric subsystem SS4 is effective to create the forth intermediate image IMI4 from the third intermediate image and allows to adjust Petzval sum and axial color aberration by means of negative refractive power provided by LG42 close to a pupil surface PS4 where concave mirror CM4 is situated. The fifth, refractive subsystem SS5 includes in this order a positive lens group LG51 (identical to LG32 and used twice), the quarter wave plate Q3 (which is used twice in opposite directions), the beam splitter including the beam splitter surface BSS used in reflection to deflect radiation coming from the concave mirror CM4 towards the image surface, a quarter wave plate Q4 and the positive lens group LG52 prior to the fith intermediate image IMI5. Structure and function of the sixth subsystem SS6 is essentially similar to that of forth subsystem SS4 in Fig. 1. The aperture stop AS is arranged between the positive lens groups LG43, LG44 closest to image surface. As an alternative, the aperture stop may be positioned at or close to one of the concave mirrors CM2 or CM4. System having an aperture stop close to a concave mirror are disclosed, for example, in WO 2004/010164 A.

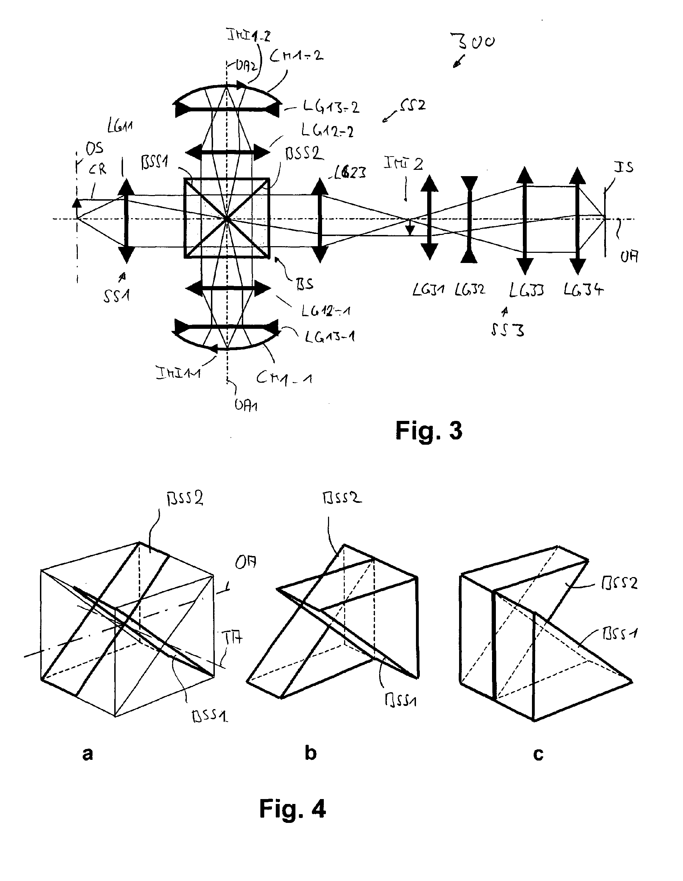

Fig. 3 shows a catadioptric projection objective 300 having a geometric beam splitter BS with two planar beam splitter surfaces BSS1, BSS2 arranged side by side at the first pupil surface within the first imaging subsystem SS1 to obtain a geometrical beam splitting of the impinging beam at the pupil surface (also called "pupil splitting"). Two partial beams propagating in generally opposite directions are thereby obtained. The intermediate images formed by each of the partial beams are complete intermediate images having about half the intensity of a "regular" intermediate image. As the partial beams are recombined to form the combined intermediated image or a final image, the "semi pupils" interfere to form one single image (or intermediate image). As any inaccuracy upon recombining the partial beams will cause errors within the final image the overlay (superposition) of the partial beams must be effected as precisely as possible.

A perspective view of the beam splitter BS is shown in Fig. 4(a). The planar beam splitter surfaces are arranged on either side of the meridional plane (paper plane of Fig. 3) and tilted with respect to a common tilt axis TA perpendicular to the meridional plane about +45° or -45° such that the beam splitting planes defined by the beam splitter surfaces are oriented perpendicular to each other. Each beam splitter surface is formed by a reflective coating reflective on both sides and disposed between hypotenuse surfaces of adjacent transparent isosceles prisms. The optical axis is thereby "split" or duplicated into two coaxial sections OA1, OA2 oriented perpendicular to the sections of the optical axis perpendicular to the object and image surface. The catadioptric first subsystem SS1 is thereby split into two partial systems (or branches), each including a concave mirror CM1-1, CM1-2, respectively, which are coaxial and facing each other.

From an optical point of view, each branch of the first subsystem SS1 includes the same sequence of optical elements explained exemplarily using the lower branch including CM1-1 shown in Fig. 3. A positive lens group LG11 is disposed immediately downstream of the object surface. The subsequent beam splitter surface BSS1 is arranged in the first pupil surface. In a double passed region between the beam splitter and the respective concave mirror CM1-1 there are disposed a positive lens group LG12-1 in an intermediate zone between the pupil surface and the concave mirror, and the negative lens group LG13-1 immediately in front of the concave mirror CM1-1. The concave mirror is arranged in a field surface (local maximum for chief ray height, marginal ray height = 0). In this case, the intermediate image is imaged into itself. Only field dependent aberrations are influenced by the concave mirror. A subsequent second subsystem SS2 is also split into two partial systems, each including the lens groups between the respective concave mirror and the beam splitter and a positive lens group LG23 downstream of the beam splitter surface.

Radiation coming from the object surface is essentially collimated by lens group LG11 to obtain essentially parallel rays at the first pupil surface where the first and second beam splitter surfaces BSS1 and BSS2 are disposed. Radiation on the viewer side of the meridional plane of Fig. 3 impinges on the object-side reflecting surface of the first beam splitter surface BSS1 and is reflected towards the lower concave mirror CM1-1. Simultaneously, radiation on the far side of the meridional plane (beyond the drawing plane in Fig. 3) is reflected on the object-side reflecting surface of second beam splitter surface BSS2 towards the upper concave mirror CM1-2. Consequently, the pupil is geometrically split into two half pupils, whereby two partial beams propagating in opposite directions towards concave mirrors are formed. In each branch, the subsequent sequence of positive power and weak negative power forms a "partial intermediate image" IMI1-1 or IMI1-2 on the respective concave mirrors CM1-1, CM1-2. The partial intermediate images are complete intermediate images with half intensity and lower resolution when compared to an intermediate image formed in a system without pupil splitting.

The respective catadioptric groups including a concave mirror and negative refractive power immediately in front of that concave mirror provide a major part of the image curvature correction. Radiation from the first partial intermediate image IMI1-1 is then guided towards the image-side of the second beam splitter surface BSS2 and reflected therefrom towards the image surface IS. Simultaneously, radiation from the second partial intermediate image IMI1-2 is guided towards the image-side reflecting surface of the first beam splitter surface BSS1, and reflected towards the image surface. Here, the geometric beam splitter BS serves to recombine the partial beams in a geometrically correct arrangement upstream of the positive lens group LG23 which contributes to form the second intermediate image IMI2. The second intermediate image IMI2 is a superposition of the images of the first and second partial intermediate images IMI1-1 and IMI1-2 formed on the concave mirrors. The subsequent refractive subsystem SS3 similar to SS4 of Fig. 1 serves to re-image the second intermediate image IMI2 onto the image surface on a reduced scale.

It is worth to note that the geometric pupil splitting exemplarily shown in the system 300 allows to use an axially centered object field and image field, whereby drawbacks of off-axis systems can be avoided. Further, since no physical beam splitting is necessary, quarter wave plates are not necessary and problems involved with using polarized imaging radiation are avoided. Since it is desired to obtain a perfect superposition of the images of the partial intermediate images IMI1-1 and IMI1-2 to obtain the second intermediate image IMI2 it is preferred that the catadioptric groups on either side of the beam splitter are constructed identically such that a symmetric arrangement is obtained around the beam splitting.

Fig. 4 shows constructional variants of a geometric beam splitter which may be used as the beam splitter in Fig. 3. The beam splitter block of Fig. 4 (a) is formed by four identical prisms, as described. In contrast, the variants of Fig. 4(b) and 4(c) use two prisms only to provide the two beam splitting surfaces BSS1 and BSS2, each reflective on both sides.

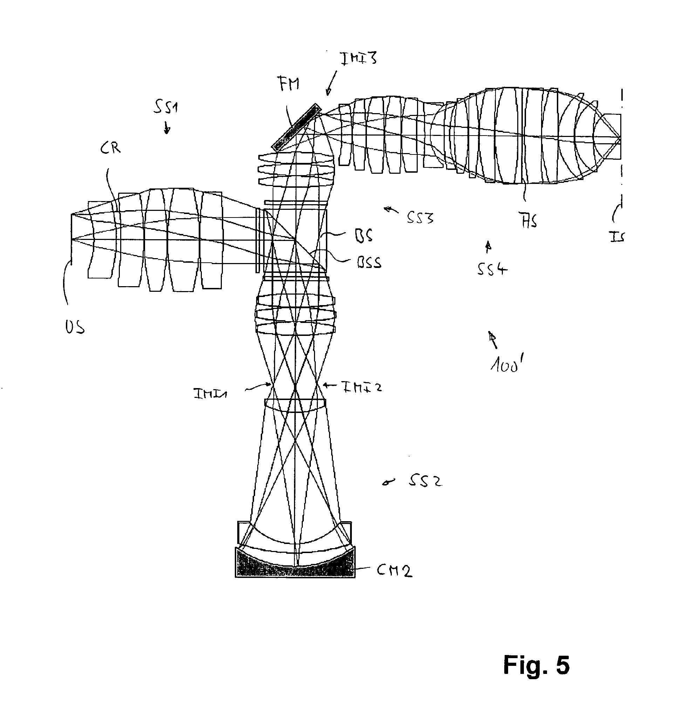

Fig. 5 shows a schematic lens section of a catadioptric projection objective 100' constructed according to principals explain in connection with Fig. 1. Therefore, the same reference identifications are used.

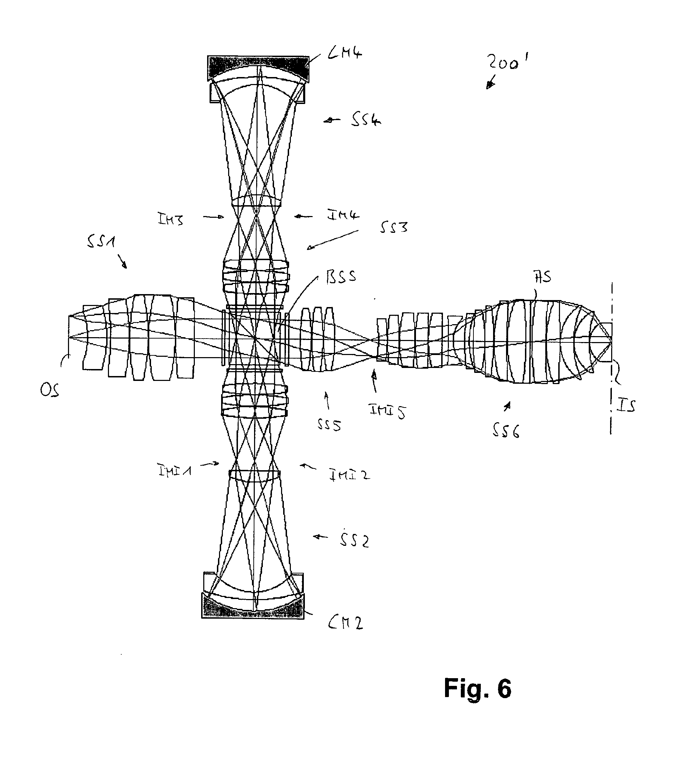

Fig. 6 shows a schematic lens section of a catadioptric projection objective 100' constructed according to principals explain in connection with Fig. 2. Therefore, the same reference identifications are used.

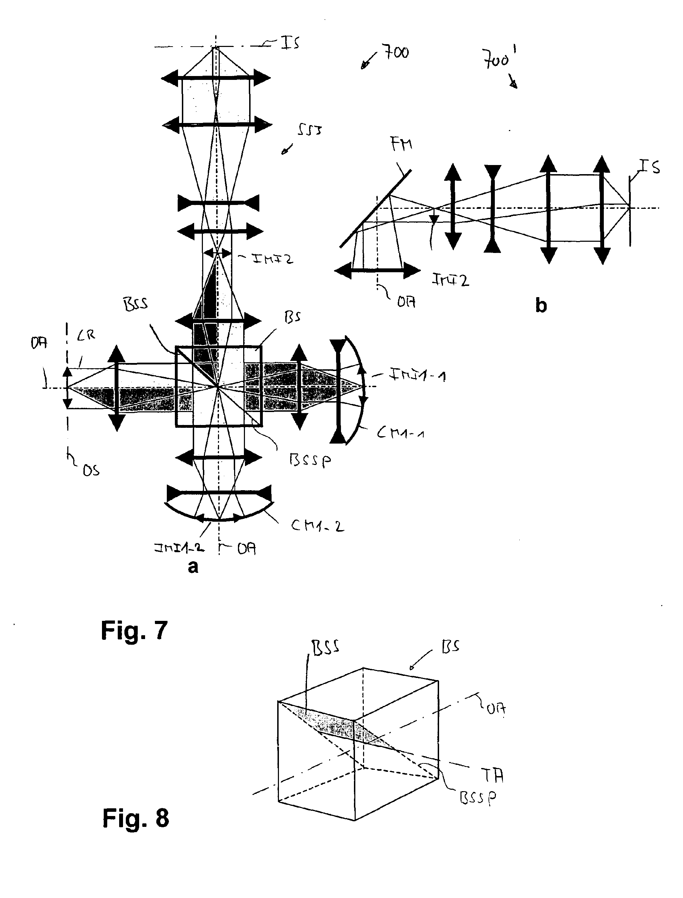

Figures 7 and 8 show other embodiments of catadioptric projection objectives 700, 700' having a geometric beam splitter arranged in a pupil surface to provide a pupil splitting such that two partial beams are obtained and each of the partial beams is reflected on a concave mirror prior to superposition of the beams to form a final image. In the beam splitter BS, which is perspectively shown in Fig. 8, includes a single beam splitter surface BSS reflective on both sides and extending only on one side of the optical axis OA up to a tilt axis TA perpendicular to the meridional plane and intersecting the optical axis. One catadioptric group including a concave mirror CM1-1 is disposed coaxial with the object side part of the first subsystem SS1, whereas another concave mirror CM1-2 is disposed at right angles thereto. The beam splitter surface BSS inclined by 45° to the optical axis is disposed such that one part of the beam impinging on the beam splitter surface plane BSSP defined by the beam splitter surface BSS is reflected towards the second concave mirror CM1-2, whereas the other part on the opposite side of the optical axis is passing the edge of the beam splitter surface directly towards the first concave mirror CM1-1.

The partial beam first passing by the beam splitter surface forms a first partial intermediate image IMI1-1 on the concave mirror and is then reflected back towards the image side reflecting surface of the beam splitter surface BSS, from where it is reflected towards the image surface IS. On the other hand, the partial beam first reflected on the beam splitter surface BSS forms a second partial intermediate image IMI1-2 on the second concave mirror CM1-2 and is reflected back towards the beam splitter, where it passes by the beam splitter surface BSS without being reflected a second time. The two partial beams are recombined downstream of the beam splitter to form a second intermediate image IMI2, which is than reimaged on to the image surface by a third, refractive subsystem SS3.

It is one benefit of this embodiment that the beam splitter BS may be formed in a classical manner by two prisms having facing hypotenuse faces, where only one half of the contact area is coated with the reflective coating (reflective on both sides) to form the beam splitter surface BSS. In this embodiment, catadioptric groups having no or little optical power are arranged close to or at the partial intermediate images IMI1-1 and IMI1-2. These groups are essentially formed by the respective concave mirrors and a negative lens group immediately in front of the mirror and contribute to Petzval sum correction as well as to the superposition of the pupils. While object surface and image surface are perpendicular to each other in the embodiment of Fig. 7a, a parallel arrangement of object surface and image surface is obtained in the variant of Fig. 7(b) where a planar folding mirror FM is included between the beam splitter and the image surface, e.g. optically upstream of the second intermediate image IMI2.

It is to be understood that all systems described above may be complete systems for forming a real image (e.g. on a wafer) from a real object. However, the systems may be used as partial systems of larger systems. For example, the "object" for a system mentioned above may be an image formed by an imaging system (relay system) upstream of the object plane. Likewise, the image formed by a system mentioned above may be used as the object for a system (relay system) downstream of the image plane.

The above description of the preferred embodiments has been given by way of example. From the disclosure given, those skilled in the art will not only understand the present invention and its attendant advantages, but will also find apparent various changes and modifications to the structures and methods disclosed. It is sought, therefore, to cover all changes and modifications as fall within the spirit and scope of the invention, as defined by the appended claims, and equivalents thereof.

The contents of all the claims is made part of this description by reference.

## Claims

1. A catadioptric imaging system for imaging an object field arranged in an object surface of the imaging system onto an image field arranged in an image surface of the imaging system while creating at least one intermediate image comprising:
at least two imaging subsystems concatenated at an intermediate image such that the intermediate image formed by an imaging subsystem immediately upstream of that intermediate image forms the object of a subsequent imaging subsystem immediately downstream of that intermediate image, wherein each imaging subsystem includes a pupil surface and at least one of the imaging subsystems is a catadioptric or catoptric imaging subsystem including a concave mirror;
a beam splitter having at least one planar beam splitter surface;
the beam splitter surface being arranged at or optically near to a pupil surface.

2. Imaging system according to claim 1, wherein the beam splitter surface is arranged at a pupil surface such that a beam splitter surface plane defined by the beam splitter surface intersects the optical axis essentially at a position where a chief ray of the imaging process intersects the optical axis, so that the condition H = |h_{C}/h_{M}|< 0.1 is satisfied for the ray height ratio H, where h_{C} is the chief ray height and h_{M} is the marginal ray height of the imaging process.

3. Imaging system according to claim 1 or 2, wherein the beam splitter is arranged in a first imaging subsystem immediately downstream of the object surface.

4. Imaging system according to one of the preceding claims, wherein the beam splitter is a physical beam splitter having at least one polarization selective beam splitter surface.

5. Imaging system according to one of the preceding claims, wherein the object field and image field are positioned symmetrically around the optical axis (on-axis field).

6. Imaging system according to one of the preceding claims 1 to 4, wherein the beam splitter is a geometric beam splitter having at least one fully reflective beam splitter surface and wherein the object field and image field are positioned symmetrically around the optical axis (on-axis field).

7. Imaging system according to one of the preceding claims, wherein the beam splitter has a first beam splitter surface inclined to the optical axis about a first tilt axis to define a first beam splitting plane and a second beam splitter surface inclined to the optical axis about a second tilt axis to define a second beam splitter plane inclined with respect to the first beam splitter plane, the first and second beam splitter surface being arranged at a pupil surface such that a radiation beam impinging on the first and second beam splitter surface is split into a first and at least one second partial beam with different propagation direction at the pupil surface.

8. Imaging system according to claim 7, wherein the first and second beam splitter surface are fully reflecting mirror surfaces arranged side by side to form a geometric beam splitter.

9. Imaging system according to claim 7 or 8, wherein the first beam splitter surface and the second beam splitter surface are inclined about the same tilt axis and include a 90° angle between the beam splitter surfaces.

10. Imaging system according to one of the preceding claims 1 to 6,
wherein the beam splitter has a beam splitter surface entirely arranged on a first side of the optical axis such that a portion of a radiation beam impinging on the beam splitter on the first side of the optical axis is reflected by the beam splitter surface and a second portion of the radiation beam impinging on the second side of the optical axis opposite to the first side is passing by the beam splitter surface and is transmitted by the beam splitter.

11. Imaging system according to claim 10, wherein the beam splitter surface is arranged at a pupil surface.

12. Imaging system according to one of the preceding claims, wherein the imaging system has an image-side numerical aperture NA > 0.6.

13. A catadioptric imaging system for imaging an object field arranged in an object surface of the imaging system onto an image field arranged in an image surface of the imaging system while creating at least one intermediate image comprising:
a geometric beam splitter having at least one fully reflective planar beam splitter surface arranged at a pupil surface such that a beam splitter surface plane defined by the beam splitter surface intersects the optical axis essentially at a position where a chief ray of the imaging process intersects the optical axis so that the condition H = |h_{C}/h_{M}|< 0.1 is satisfied for the ray height ratio H, where h_{C} is the chief ray height and h_{M} is the marginal ray height of the imaging process;
wherein the object field and image field are positioned symmetrically around the optical axis (on-axis field).

14. A catadioptric imaging system for imaging an object field arranged in an object surface of the imaging system onto an image field arranged in an image surface of the imaging system while creating at least one intermediate image comprising:
a plurality of imaging subsystems concatenated at an intermediate image such that the intermediate image formed by an imaging subsystem immediately upstream of that intermediate image forms the object of a subsequent imaging subsystem immediately downstream of that intermediate image, wherein at least one imaging subsystem is a catadioptric or catoptric imaging subsystem including a concave mirror;
a beam splitting device that geometrically separates at least two parts of a light beam emerging from one object point into partial beams;
a beam uniteing device which joins the partial beams again into a single beam;
the separated partial beams traveling through different subsystems after separation until reuniting into a single beam by the uniteing device.

15. Imaging system according to claim 14, wherein the subsystems used by the different beam partial beams are catadioptric subsystems including at least a concave mirror.

16. Imaging system according to claim 14 or 15, wherein the beam splitting device and the beam uniting device are positioned near a pupil surface of a subsystem essentially at a position where a chief ray of the imaging process intersects an optical axis of the imaging system so that the condition H = |h_{C}/h_{M}|< 0.1 is satisfied for the ray height ratio H, where h_{C} is the chief ray height and h_{M} is the marginal ray height of the imaging process.

17. Imaging system according to claim 16, wherein the beam splitting device and the beam uniteing device are forming a single device having common light entry and exit surfaces.

18. Imaging system according to one of claims 14 to 17, wherein optical axes of subsystems guiding the separated partial beams are foming an angle of one of 90° and 180° after separation and 0° after reuniteing.

19. A catadioptric imaging system for imaging an object field arranged in an object surface of the imaging system onto an image field arranged in an image surface of the imaging system while creating at least one intermediate image comprising:
a plurality of imaging subsystems concatenated at an intermediate image such that the intermediate image formed by an imaging subsystem immediately upstream of that intermediate image forms the object of a subsequent imaging subsystem immediately downstream of that intermediate image;
wherein at least one imaging subsystem is a catadioptric or catoptric imaging subsystem including a concave mirror; and
wherein at least one imaging subsystem includes a beam splitting device near a pupil position of the subsystem, but no concave mirror near the pupil position or the beam splitting device.
